Europäisches Patentamt

European Patent Office

Office européen des brevets

(19)

(11) **EP 0 887 936 A1**

(12) **EUROPEAN PATENT APPLICATION**

(43) Date of publication:
30.12.1998 Bulletin 1998/53

(51) Int. Cl.$^6$: **H03L 1/00**, H03K 3/0231

(21) Application number: 97830295.8

(22) Date of filing: 24.06.1997

(84) Designated Contracting States:
AT BE CH DE DK ES FI FR GB GR IE IT LI LU MC
NL PT SE

(71) Applicant:
STMicroelectronics S.r.l.
20041 Agrate Brianza (Milano) (IT)

(72) Inventors:
• Celant, Luca
20159 Milano (IT)

• Demicheli, Marco
22070 Binago Como (IT)
• Bruccoleri, Melchiorre
20017 RHO Milano (IT)
• Rigazio, Luca
13043 Cigliano (Vercelli) (IT)

(74) Representative:
Maggioni, Claudio et al
c/o JACOBACCI & PERANI S.p.A.
Via Visconti di Modrone, 7
20122 Milano (IT)

(54) **An oscillator with a low supply voltage**

(57) The controllable-frequency oscillator described is of the astable multivibrator type with two transistors (Q1, Q2) coupled to one another by means of a capacitor (C) and a positive-feedback circuit. In order to reduce the supply voltage of the oscillator to the minimum, the positive-feedback circuit is constituted by a differential amplifier (T3, T4, R3, R4 and G5).

FIG. 2

EP 0 887 936 A1

## Description

The present invention relates to a controllable-frequency oscillator as defined in the Preamble of Claim 1.

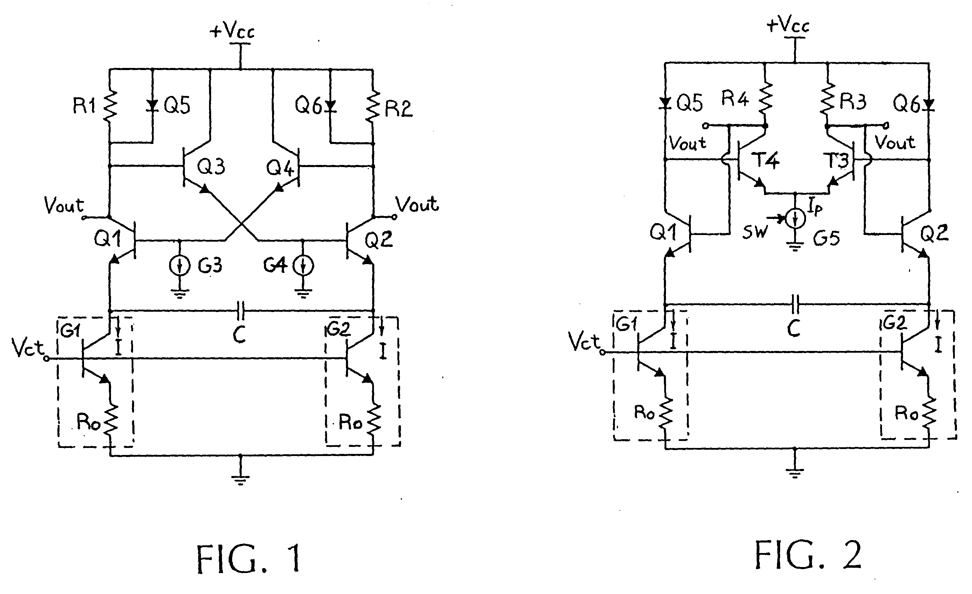

Figure 1 of the appended drawings shows the circuit diagram of a known oscillator which can advantageously be formed in an integrated circuit and the frequency of which can be controlled by variation of a voltage at its control terminal. More particularly, the circuit is constituted by two branches each comprising an npn transistor Q1 or Q2. The emitters of the transistors Q1 and Q2 are connected to a first supply terminal, indicated by the earth symbol, via respective controllable current generators G1 and G2, and their collectors are connected to a second supply terminal +Vcc via respective load elements each constituted by a resistor (R1, R2) connected in parallel with a diode (Q5, Q6) biased in the conduction direction. The generators G1 and G2 are constituted by two npn transistors having their emitters connected to earth via respective resistors Ro and their bases connected to one another and to a voltage control terminal Vct. The emitters of the transistors Q1 and Q2 are connected to one another by means of a capacitor C and the collector of each is connected to the base of the other via a respective npn transistor Q3 or Q4 in the "emitter follower" configuration. More precisely, the collectors of the transistors Q3 and Q4 are connected to the terminal +Vcc, their bases are connected to the collectors of Q1 and of Q2, respectively, and their emitters are connected both to the bases of Q2 and of Q1, respectively, and to the earth terminal via respective constant-current generators G4 and G3.

As is known, the circuit described operates as an astable multivibrator in which the two transistors Q1 and Q2 change alternately from the conduction state to the cut-off state as a result of the positive feedback due to the crossed coupling between their bases and their collectors, at a frequency determined by the capacitance of the capacitor C and by the currents of the generators G1 and G2. If the circuit is symmetrical and if the currents of the generators G1 and G2 are large enough to bring about, in the resistors R1 and R2, both of resistance R, voltage drops sufficient to exceed the threshold voltages of the associated diodes Q5 and Q6, there will be, at the collectors of the transistors Q1 and Q2, voltage signals constituted by complementary square-waves of frequency

$$F = I/4CV_D \qquad (1)$$

where I is the current of the generators G1 and G2, C is the capacitance of the capacitor indicated by the same symbol in the drawing and $V_D$ is the voltage drop in a forward biased diode.

If the current I is not large enough to permit forward conduction through the diodes Q5 and Q6, or if the diodes Q5 and Q6 are missing, the frequency depends on the voltage drop IR in the resistors R1 and R2. The voltage at the terminals of the capacitor C has a sawtoothed waveform of amplitude A=2Vo where Vo is the voltage drop in a load element ($V_D$ or IR).

The circuit is suitable for use as an oscillator the frequency of which can be controlled by regulation of the current of the current generators G1 and G2, in this example, by the application of a suitable control voltage to the terminal Vct.

The circuit described above has to be used with supply voltages no less than a limit value which is set by its structure. In order to determine this limit value, the circuit is considered in the balanced operating condition, that is, in the extremely short transitory state in which the switching of the transistors takes place; in these conditions, there is a maximum voltage drop in the circuit. If all of the voltage drops in the forward biased diodes and base-emitter junctions are considered to be equal and the value of each of these drops is indicated $V_{BE}$, the overall drop is given by $4V_{BE}+IRo$. In practice, this limit value is slightly less than 4V.

However, the continual reduction in the dimensions of integrated circuits, which are characterized by MOS transistor-channel lengths as small as 0.25μm, and the increase in data-processing and -transfer speeds require ever lower supply voltages (2.5-3.5V).

The object of the present invention is to provide an oscillator of the type described above which can operate with supply voltages lower than the usual voltages for known oscillators.

This object is achieved, according to the invention, by the provision of the oscillator defined and characterized in Claim 1.

The invention will be understood better from the following detailed description of an embodiment thereof, given by way of example with reference to the appended drawing, in which:

- Figure 1, which has already been described, shows the circuit diagram of a known oscillator, and
- Figure 2 shows the circuit diagram of an oscillator according to the invention.

In the circuit of Figure 2, components identical or corresponding to those of the circuit of Figure 1 are indicated by the same reference symbol. The circuit of Figure 2 differs from that of Figure 1 mainly in that a balanced differential amplifier is provided, instead of the transistors Q3 and Q4 in the "emitter follower" configuration, as coupling means for the positive feedback between the two transistors Q1 and Q2. More particularly, the differential amplifier comprises two npn transistors T3 and T4 of which the emitters are connected to one another and to the earth terminal via a current generator G5 the current Ip of which can be regulated at a terminal SW thereof, each of the collectors is connected to the voltage supply terminal Vcc by means of a respective resistor R3 or R4, and the bases are connected to the collectors of the transistors Q2 and Q1, respectively. The collectors of T3 and T4 are also connected to the bases of the transistors Q2 and Q1, respectively, and each can be taken as the output terminal Vout of the oscillator.

The operation of the oscillator of Figure 2 will now be considered. It is assumed that, at a given moment, T3 is conducting and T4 is cut off. In these conditions, since the base of Q2 is connected to the collector of T3, it is at a relatively low voltage such as to keep Q2 cut off whereas, since the base of Q1 is connected to the collector of the transistor T4 which is cut off, it is at a voltage very close to the supply voltage +Vcc, such as to keep the transistor Q1 conducting; moreover, the voltage at the emitter of Q2 is greater than that at the emitter of Q1; at this moment, however, the capacitor starts to be discharged through the generator G1 so that the voltage at the emitter of Q2 starts to fall. When this voltage has fallen to a value of a $V_{BE}$ (base-emitter voltage of Q2 in forward conduction) lower than that of the base of Q2, this transistor starts to conduct; this gives rise to a positive feedback which causes the multivibrator to switch. More particularly, the voltage of the collector of Q2, which is higher than that of the collector of Q1, starts to fall, the pair T3, T4 of the differential amplifier starts to switch, that is, T4 starts to conduct and T3 conducts less and this causes Q1 to be cut off gradually and Q2 to conduct increasingly. The voltage at the emitter of Q2 follows that of the base of Q2 with the difference of a $V_{BE}$ and thus rises whereas the voltage at the emitter of Q1 follows the voltage at the emitter of Q2 with the difference of the drop in the capacitor C because the voltage at the terminals of the capacitor cannot change instantaneously, contributing to the cutting-off of Q1. The condition symmetrical to the starting condition is thus reached, that is, the condition in which Q1 is cut off and Q2 is conducting and therefore T4 is conducting and T3 is cut off, and the process is repeated in reverse.

It can easily be seen that, in balanced operating conditions, the overall voltage drop in the oscillator is $3V_{BE} + IRo$, that is, it is lower than that of the known oscillator by one $V_{BE}$. Since the value to be considered for one $V_{BE}$ is about 0.8 V, the supply voltage of the oscillator according to the invention can be lower than that of the known oscillator by the same amount. In practice, therefore, the limit value for the supply voltage falls from about 4V to about 3.2V.

It should also be noted that, with the oscillator according to the invention, the amplitude of the oscillation can very easily be made independent of temperature. As in the known circuit of Figure 1, the voltage at the terminals of the capacitor C has a sawtoothed waveform. In the known circuit, the sawtooth amplitude (A = 2Vo) is determined by the voltage drop in the load, which depends on the temperature. Various circuit measures are known for preventing this temperature dependence. However, these measures are quite complex and in any case increase the lower limit for the supply voltage.

In the circuit according to the invention, the sawtooth amplitude depends on the voltage drop Ip · R, that is, on the current of the generator G5 and on the resistance R of the resistors R3 and R4 which, in this case, are considered to be equal. The generator G5 is advantageously of the known type the current of which is produced by the voltage of a temperature-independent reference-voltage source, for example, a "bandgap" referenced voltage source applied to a resistor. According to one embodiment of the invention, the resistor is made of the same material (for example, polysilicon) and by the same process as the resistors R3 and R4 so that the current Ip, which is given by the ratio between the reference voltage and the resistance of the resistor, and hence also the amplitude of oscillation, will be substantially independent of the temperature.

Independence from temperature is thus achieved by a simple circuit measure and, in particular, without increasing the lower limit for the supply.

**Claims**

1.  A controllable-frequency oscillator of the astable multivibrator type, comprising two transistors (Q1, Q2) each having its emitter coupled to the emitter of the other by capacitive means (C) and to a first voltage-supply terminal via a respective current generator (G1, G2) and its collector connected to a second voltage-supply terminal (+Vcc) via a respective load element (Q5, Q6) and to the base of the other by coupling-circuit means, the current generators (G1, G2) having a terminal (Vct) for the regulation of their respective currents,

    characterized in that the coupling-circuit means comprise a differential amplifier (T3, T4, R3, R4, G5) having two differential inputs each connected to a collector of the two transistors (T3, T4) and two differential outputs each connected to a base of the two transistors (Q1, Q2).

2.  An oscillator according to Claim 1, in which the differential amplifier comprises two further transistors (T3, T4) having their emitters connected to one another and to the first voltage supply terminal via a further current generator (G5), each of their bases connected to a respective differential input, and each of their collectors connected to a respective differential output and, via a respective resistive means (R3, R4), to the second voltage-supply terminal (+Vcc).

3.  An oscillator according to Claim 2, in which the further current generator (G5) can be regulated by a voltage at a control terminal (SW) thereof.

4.  An oscillator according to Claim 3, in which the further current generator (G5) comprises a temperature-independent reference-voltage source and a resistor formed of the same material and by the same process by which the resistive means (R3, R4) of the differential amplifier are formed, the current (Ip) of the current generator (G5) being produced by the voltage of the source of the reference voltage applied to the resistor.

FIG. 1

FIG. 2

EP 0 887 936 A1

European Patent
Office

**EUROPEAN SEARCH REPORT**

Application Number

EP 97 83 0295

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X<br>Y | US 5 543 742 A (TAKEDA ISOSHI ET AL)<br>* column 2, line 32 – column 4, line 53; figures 4,6 * | 1,2<br>3,4 | H03L1/00<br>H03K3/0231 |
| X | US 5 289 502 A (KAWASAKI SOMEI)<br>* figure 2 * | 1,2 | |
| Y | US 5 311 141 A (UMEYAMA TAKEHIKO ET AL)<br>* column 16, line 52 – column 17, line 14; figure 6 * | 3,4 | |
| A | US 4 323 854 A (HESTER RICHARD E)<br>* column 3, line 31 – line 46; figure 1 * | 3,4 | |
| A | US 4 853 646 A (JOHNSON TERRY J ET AL)<br>* abstract; figure 2 * | 3,4 | |

**TECHNICAL FIELDS SEARCHED (Int.Cl.6)**

H03K
H03F

The present search report has been drawn up for all claims

| Place of search | Date of completion of the search | Examiner |
|---|---|---|
| THE HAGUE | 14 November 1997 | Peeters, M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)